# EUROPEAN PATENT APPLICATION

(11) **EP 1 737 035 A1**
(43) Date of publication of application: **27.12.2006**
(21) Application number: 05727986.1
(22) Date of filing: 31.03.2005
(51) Int. Cl.: H01L 23/36, H05K 7/20

(54) **HEAT SINK MANUFACTURING METHOD**

(30) Priority: 31.03.2004 JP 2004104919
(71) Applicant: Jisouken Co. Ltd., Tokyo 105-0001 (JP)
(72) Inventor: HONMA, Mitsuo, 2790026 (JP)
(74) Representative: Rees, Alexander Ellison
(86) International application number: PCT/JP2005/006309
(87) International publication number: WO 2005/096376

(57) **Abstract**

This invention seeks to provide a method for manufacturing a heat sink capable of enhancing the fixing strength and heat conductivity between a radiating substrate and radiating fins. The heat sink 100 comprises radiating fins 2 formed by winding a metal wire having high thermal conductivity in a coil shape, which is secured on a flat radiating substrate 1 formed of a flat plate having high thermal conductivity The radiating fins 2 are formed by flattening the radiating fins so as to bring flattened loops of the coiled radiating fins of metal wire into close contact with one another and securing the flattened side edge portions of the radiating fins 2 onto the radiating substrate 1 by soldering.

## Description

### TECHNICAL FIELD

This invention belongs to the technical field of a method for manufacturing a heat sink mounted on a semiconductor device to radiate heat generated within the semiconductor device to gaseous material, fluid material or the like.

### BACKGROUND OF THE ART

There has been a heat sink in which radiating fins formed by winding a metal wire having high thermal conductivity in a coil shape is secured on a flat radiating substrate formed of a flat plate having high thermal conductivity. Since the coiled radiating fins have the curved points in touch with the flat surface of the radiating substrate to be secured on the radiating substrate, the heat sink suffers from the disadvantage that fixing strength of the radiating substrate and radiating fins are weak and heat conduction from the radiating substrate to the radiating fins is not sufficient. Thus, there have been the needs to develop a method for manufacturing a heat sink creative with a mechanism for fixing the radiating substrate and the radiating fins.

There has been heretofore a heat sink manufacturing method as typically described below. "Patent Literature 1" discloses a method for manufacturing a heat sink having radiating fins adhered to a radiating substrate with an adhesive. "Patent Literature 2" discloses a method for manufacturing a heat sink having radiating fins welded to a radiating substrate by soldering or laser welding. "Patent Literature 3" discloses a method for manufacturing a heat sink having radiating fins joined to a radiating substrate by soldering.

The heat sink manufacturing methods described in "Patent Literatures 1-3" are designed for the purpose of improving the heat conductivity between the radiating substrate and the radiating fins with increasing the strength of the union between the radiating substrate and radiating fins by enlarging soldering deposit formed as punctate contact portions by welding between the flat surface of the radiating substrate and the curved parts of the radiating fins.

However, such a heat sink manufacturing method as described in "Patent Literatures 1-3" has fundamental problems of incapable of enhancing the fixing strength and heat conductivity between the radiating substrate and the radiating fins because the radiating fins are in point contact with the radiating substrate.

Patent Literature 1: Japanese Patent Application Publication HEI 4-71257A
Patent Literature 2: Japanese Patent Application Publication HEI 6-275746A
Patent Literature 3: Japanese Patent Application Publication HEI 11-54676A

### DISCLOSURE OF INVENTION

### PROBLEMS TO BE SOLVED BY THE INVENTION

In consideration of the situations described above, the present invention seeks to provide a method for manufacturing a heat sink capable of enhancing the fixing strength and heat conductivity between a radiating substrate and radiating fins.

### MEANS OF SOLVING THE PROBLEMS

The method for manufacturing the heat sink according to the present invention for attaining the object described above is featured by the subject matters mentioned in the claims.

That is, the present invention seeks to provide a method for manufacturing a heat sink having radiating fins formed by winding a metal wire into a coil and secured on radiating substrate, which is featured in that the radiating fins are formed by flattening the radiating fins so as to bring flattened loops of the coiled radiating fins of metal wire into close contact with one another and securing the flattened side edge portions of the radiating fins onto the radiating substrate by soldering.

According to the method as above, complex uneven surface can be formed by the flattened loops of the metal wire coil of each radiating fin, which are in mutual contact with one another by soldering so as to allow soldering deposit resulting from soldering to infiltrate toward the center of the radiating fin by capillary action, consequently to increase the punctate contact zone between the flat surface of the radiating substrate and the curved parts of the radiating fin. The flattening of the radiating fin is conceptually intended for not only the entire radiating fin but also a part of the radiating fin at the peripheral edge portion.

Further, the present invention seeks to provide a method for manufacturing a heat sink having radiating fins formed by winding a metal wire into a coil and secured on radiating substrate, which is featured in that slit-like insertion grooves are formed in the radiating substrate and the radiating fins are formed by flattening the radiating fins so as to bring flattened loops of the coiled radiating fins of metal wire into close contact with one another and inserting the flattened side edge portions of the radiating fins into the insertion grooves in the radiating substrate to be secured onto the radiating substrate by soldering.

According to the method as above, complex uneven surface can be formed by the flattened loops of the metal wire coil of each radiating fin, which are in mutual contact with one another by soldering so as to allow soldering deposit resulting from soldering to infiltrate toward the center of the radiating fin by capillary action while preventing the soldering deposit from flowing out by the insertion grooves, consequently to increase the punctate contact zone between the flat surface of the radiating substrate and the curved parts of the radiating fin.

Further, the present invention seeks to provide a method for manufacturing a heat sink having radiating fins formed by winding a metal wire into a coil and secured on radiating substrate, which is featured in that the radiating fins are formed by flattening the radiating fins and the radiating fins having side edge portions adhered to the radiating substrate with a heat conductive adhesive while being in contact with the radiating substrate.

According to the method as above, complex uneven surface can be formed by the flattened loops of the metal wire coil of each radiating fin, which are in mutual contact with one another by the adhesive so as to allow deposit made of the adhesive to infiltrate toward the center of the radiating fin by capillary action, consequently to increase the punctate contact zone between the flat surface of the radiating substrate and the curved parts of the radiating fin.

Further, the present invention seeks to provide a method for manufacturing a heat sink having radiating fins formed by winding a metal wire into a coil and secured on radiating substrate, which is featured in that slit-like insertion grooves are formed in the radiating substrate and the radiating fins are formed by flattening the radiating fins so as to bring flattened loops of the coiled radiating fins of metal wire into close contact with one another and inserting the flattened side edge portions of the radiating fins into the insertion grooves in the radiating substrate to be secured onto the radiating substrate by the adhesive.

According to the method as above, complex uneven surface can be formed by the flattened loops of the metal wire coil of each radiating fin, which are in mutual contact with one another by the adhesive so as to allow deposit made of the adhesive to infiltrate toward the center of the radiating fin by capillary action, consequently to increase the punctate contact zone between the flat surface of the radiating substrate and the curved parts of the radiating fin.

Further, the present invention seeks to provide a method for manufacturing a heat sink having radiating fins formed by winding a metal wire into a coil and secured on radiating substrate, which is featured in that slit-like insertion grooves are formed in the radiating substrate and the radiating fins are formed by flattening the radiating fins so as to bring flattened loops of the coiled radiating fins of metal wire into close contact with one another, inserting the flattened side edge portions of the radiating fins into the insertion grooves in the radiating substrate, and securing the radiating fins onto the radiating substrate by deforming the insertion grooves under pressure.

According to the method as above, complex uneven surface can be formed by the flattened loops of the metal wire coil of each radiating fin, which are in mutual contact with one another by the adhesive to increase the punctate contact zone between the flat surface of the radiating substrate and the curved parts of the radiating fin by the insertion grooves in the radiating substrate, which are deformed under pressure.

Further, the present invention seeks to provide a method for manufacturing a heat sink having radiating fins formed by winding a metal wire into a coil and secured on radiating substrate, which is featured in that slit-like insertion grooves are formed in the radiating substrate and the radiating fins are formed by flattening the radiating fins so as to bring flattened loops of the coiled radiating fins of metal wire into close contact with one another, inserting the flattened side edge portions of the radiating fins into the insertion grooves in the radiating substrate, and securing the radiating fins onto the radiating substrate by deforming the insertion grooves under vibrational pressure.

According to the method as above, complex uneven surface can be formed by the flattened loops of the metal wire coil of each radiating fin, which are in mutual contact with one another by the adhesive to increase the punctate contact zone between the flat surface of the radiating substrate and the curved parts of the radiating fin by the insertion grooves in the radiating substrate, which are deformed under vibrational pressure.

That is, the present invention seeks to provide a method for manufacturing a heat sink having radiating fins formed by winding a metal wire into a coil and secured on radiating substrate, which is featured in that the radiating fins are formed by flattening the radiating fins so as to bring flattened loops of the coiled radiating fins of metal wire into close contact with one another and securing the flattened side edge portions of the radiating fins onto the radiating substrate by flash welding.

According to the method as above, complex uneven surface can be formed by the flattened loops of the metal wire coil of each radiating fin, which are in mutual contact with one another by flush welding so as to allow deposit formed by welding to infiltrate toward the center of the radiating fin by capillary action, consequently to increase the punctate contact zone between the flat surface of the radiating substrate and the curved parts of the radiating fin.

Further, the present invention seeks to provide a method for manufacturing a heat sink having radiating fins formed by winding a metal wire into a coil and secured on radiating substrate, which is featured in that slit-like insertion grooves are formed in the radiating substrate and the radiating fins are formed by flattening the radiating fins so as to bring flattened loops of the coiled radiating fins of metal wire into close contact with one another and inserting the flattened side edge portions of the radiating fins into the insertion grooves in the radiating substrate to be secured onto the radiating substrate by flash welding.

According to the method as above, complex uneven surface can be formed by the flattened loops of the metal wire coil of each radiating fin, which are in mutual contact with one another by flash welding so as to allow deposit formed by welding to infiltrate toward the center of the radiating fin by capillary action while preventing the deposit from flowing out by the insertion grooves, consequently to increase the punctate contact zone between the flat surface of the radiating substrate and the curved parts of the radiating fin.

That is, the present invention seeks to provide a method for manufacturing a heat sink having radiating fins formed by winding a metal wire into a coil and secured on radiating substrate, which is featured in that the radiating fins are formed by flattening the radiating fins so as to bring flattened loops of the coiled radiating fins of metal wire into close contact with one another and securing the flattened side edge portions of the radiating fins onto the radiating substrate by vibrational welding.

According to the method as above, complex uneven surface can be formed by the flattened loops of the metal wire coil of each radiating fin, which are in mutual contact with one another by vibrational welding so as to allow deposit formed by welding to infiltrate toward the center of the radiating fin by capillary action, consequently to increase the punctate contact zone between the flat surface of the radiating substrate and the curved parts of the radiating fin.

Further, the present invention seeks to provide a method for manufacturing a heat sink having radiating fins formed by winding a metal wire into a coil and secured on radiating substrate, which is featured in that slit-like insertion grooves are formed in the radiating substrate and the radiating fins are formed by flattening the radiating fins so as to bring flattened loops of the coiled radiating fins of metal wire into close contact with one another and inserting the flattened side edge portions of the radiating fins into the insertion grooves in the radiating substrate to be secured onto the radiating substrate by vibrational welding.

According to the method as above, complex uneven surface can be formed by the flattened loops of the metal wire coil of each radiating fin, which are in mutual contact with one another by vibrational welding so as to allow deposit formed by welding to infiltrate toward the center of the radiating fin by capillary action while preventing the deposit from flowing out by the insertion grooves, consequently to increase the punctate contact zone between the flat surface of the radiating substrate and the curved parts of the radiating fin.

Further, in any of the aforementioned methods for manufacturing the heat sink, the present invention is featured in that only the side edge portions of the radiating fins to touch the radiating substrate are flattened.

Further, in any of the aforementioned methods for manufacturing the heat sink, the present invention is featured in that only the side edge portions of the radiating fins to be fitted into the insertion grooves in the radiating substrate are flattened.

According to the methods as above, complex uneven surface can be formed by the flattened loops of the metal wire coil of each radiating fin, which are in mutual contact with one another. Consequently, the side edge portions of the radiating fins are formed densely to expedite heat conduction from the radiating substrate to the radiating fins. The metal wire loops of the radiating fins are coarse at the other portions than the side edge portions to substantially expand the heat dissipation space.

### EFFECT OF THE INVENTION

The method for manufacturing a heat sink according to the present invention has the complex uneven surface can be formed by the flattened loops of the metal wire coil of each radiating fin to increase the punctate contact zone between the flat surface of the radiating substrate and the curved parts of the radiating fin, consequently to certainly enhance the fixing strength and heat conductivity between a radiating substrate and radiating fins.

### BRIEF DESCRIPTION OF THE DRAWINGS

FIG 1 is a perspective view showing a first embodiment of the best mode for practicing a method for manufacturing a heat sink according to the invention, illustrating the processes (A) to (C) for manufacturing the heat sink.
FIG 2 is a plan view illustrating the method for manufacturing the principal part of the heat sink of FIG 1.
FIGS. 3(A) and 3(B) are side views showing the example of processing the heat sink of FIG 1, wherein the state before processing is shown in FIG 3(A) and the state after processing is shown in FIG 3(B).
FIG 4 is an enlarged longitudinal sectional view of FIG 1(C).
FIG 5 is an enlarged sectional view along X-X of FIG 4.
FIG 6 shows a modified example of the principal part of the heat sink of FIG 1.
FIG 7 is a perspective view showing a second embodiment of the best mode for practicing the method for manufacturing the heat sink according to the invention, illustrating the processes (A) to (C) for manufacturing the heat sink.
FIG 8 is a perspective view showing a third embodiment of the best mode for practicing the method for manufacturing the heat sink according to the invention, illustrating the processes (A) and (B) for manufacturing the heat sink.
FIG 9 is an enlarged longitudinal sectional view of FIG 8(B).
FIG 10 is a perspective view showing a fourth embodiment of the best mode for practicing the method for manufacturing the heat sink according to the invention, illustrating the processes (A) and (B) for manufacturing the heat sink.
FIG 11 is a perspective view showing a fifth embodiment of the best mode for practicing the method for manufacturing the heat sink according to the invention, illustrating the processes (A) and (B) for manufacturing the heat sink.

### EXPLANATION OF REFERENCES NUMERALS

- 100: Heat sink
- 1: Radiating substrate
- 11: Insertion groove
- 12: Spacer plate
- 2: Radiating fins
- 21,22: Coil
- 211, 221: Center part
- 212, 222: Flat surface
- 213, 223: Side edge portions
- 3: Solder material
- 4: Thermally-conductive adhesive
- 5: Nozzle
- 6: Holder base
- 7: Support frame
- 8: Vibration pressure plate

### BEST MODE FOR CARRYING OUT THE INVENTION

The method for manufacturing the heat sink according to the present invention will be described hereinafter with reference to the accompanying drawings.

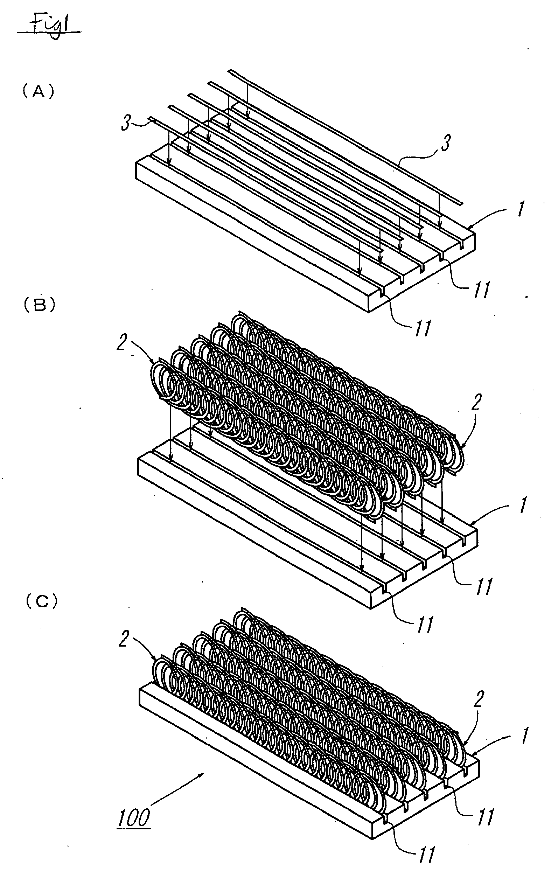

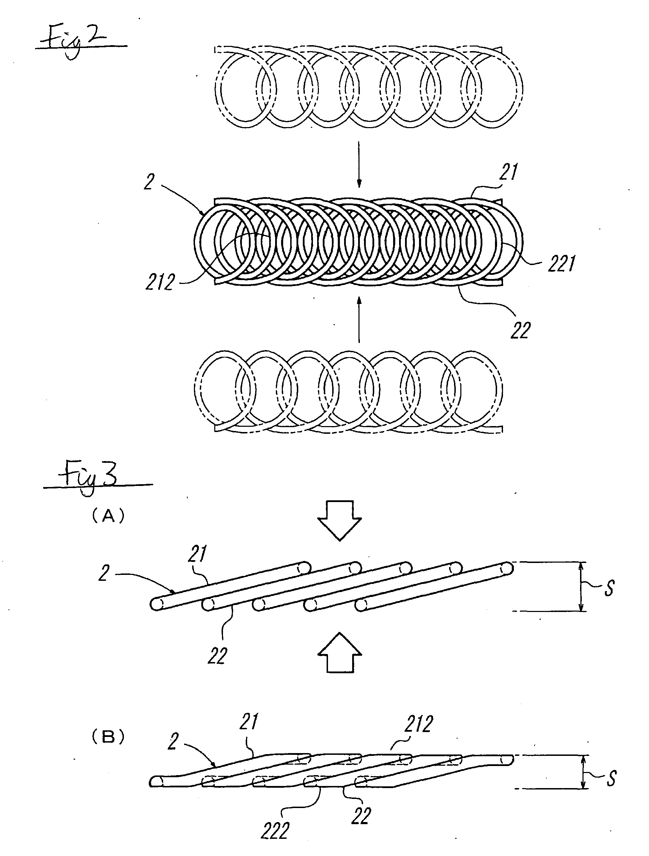

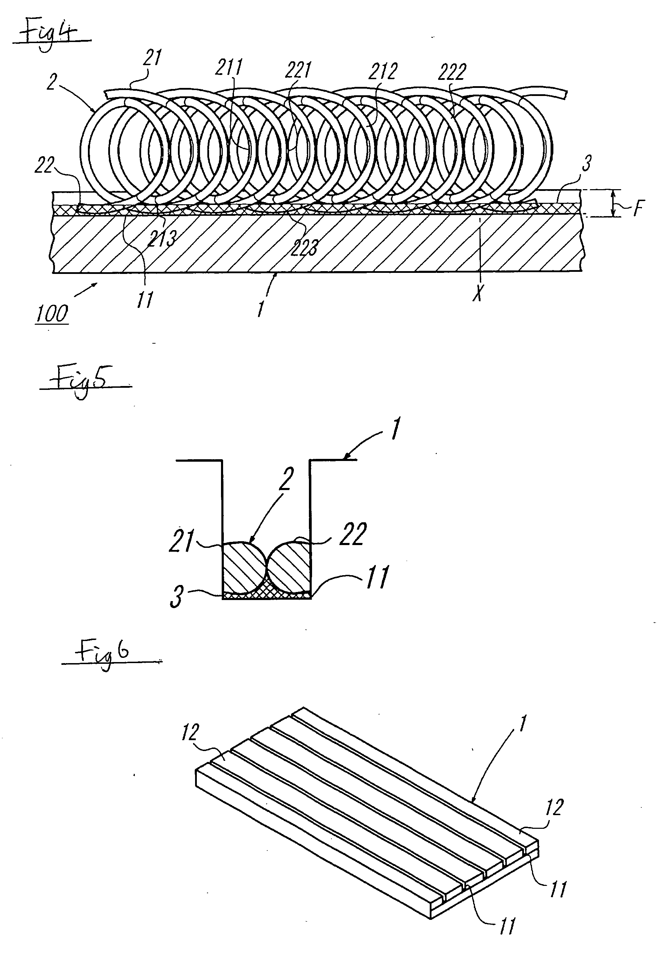

FIG 1 through FIG 6 illustrate the first embodiment of the best mode for practicing the method for manufacturing the heat sink according to the invention.

The heat sink in the first embodiment comprises a radiating substrate 1 and radiating fins 2, which are united by soldering.

The radiating substrate 1 is formed of a flat plate having high thermal conductivity To be more specific, it may be made from metallic material such as aluminum, copper, silver and gold or carbon material. As the metallic material, there may be used an alloy of such a metallic material and nickel, magnesium, zinc or silicon. As the occasion demands, it may be subjected to surface treatment with a material having no significant adverse effect on soldering to increase heat conductivity and corrosion resistivity. There are formed slit-like insertion grooves 11 in one surface of the radiating substrate 1 (opposite surface of a mounting surface to be attached to a semiconductor device). The insertion groove 11 may be formed by cutting, die-casting, or extrusion-molding.

The radiating fin 2 is formed by winding the same metal wire as the radiating substrate 1 into a coil and flattened so as to bring flattened loops of the coiled radiating fin of metal wire into close contact with one another. The radiating fins 2 may be typically assembled by interdigitating the loops of the opposed radiating fin coils 21 and 22 having the same size and wound in the opposite direction at the same pitch and then compressing the coils 21 and 22 one on top of the other to be united into one body. The coils are compressed in such a manner that the center parts 211 and 221 of the coils 21 and 22 are bent inwardly (toward the inner side of the overlaid coils) and then the front side parts of the overlaid coils 21 and 22 are crushed to form flat surfaces 212 and 222. The coils 12 and 22 of the radiating fins thus formed have the outwardly-projecting center portions 211 and 221 bent inwardly to reduce the thickness by S, consequently to form the complex uneven surface having the side edge portions 213 and 223 of the tangled metal wires.

As the material of the radiating fin 2, various kinds of materials similarly to the aforementioned radiating substrate 1 may be used. To be more specific, metallic material such as aluminum, copper, silver and gold or an alloy of such a metallic material and nickel, magnesium, zinc or silicon. In particular, affordable aluminum materials having high thermal conductivity are good for the radiating fin.

An anticorrosion metal may be used as the metal wire of the radiating fin 2. Since the heat sink may be used in a corrosion-prone environment depending on its usage, the radiating fin of anticorrosion metal is adequate in such an environment. As the anticorrosion metal, titan, titanium alloy and stainless steel may be included.

The metal wire for the radiating fin 2 may be subjected to surface treatment for increasing heat conductivity and corrosion resistivity according to need. To be more specific, the surface treatment such as copper plating and silver plating is suitable. In the case of using aluminum or aluminum alloy, it is desirable to subjecting the surface of the radiating fin to anodic oxide coating (alumite treatment). This treatment brings about effects of increasing the corrosion resistivity and decreasing heat resistance at the contact points at which the coil loops of the radiating fin are in mutual contact with the radiating substrate, thus to heighten the heat dissipation capacity of the heat sink. A commonly known surface treatment may be applied to the method for manufacturing the heat sink, e.g. an electrolytic method for forming a plating layer on a processing object used as a positive electrode in an electrolyte solution such as of oxalic acid, sulfuric acid and phosphoric acid. As the anodic oxide coating treatment, there are a white alumite treatment and a black alumite treatment, which both are applicable to this invention.

On the surface of the metal wire, a coating including ferrite may be formed according to need. The ferrite of the coating has an effect of absorbing electromagnetic wave, consequently to provide an electromagnetic wave absorbing capacity to the heat sink 100 thus treated. In particular, the radiating fin 2 of the metal wire has the uneven surface inherently reflecting diffusely the electromagnetic wave, thus to synergistically increase the electromagnetic wave absorbing capacity.
As the ferrite, there are soft magnetic ferrite (soft ferrite) and hard magnetic ferrite (hard ferrite), either, or a combination of both, of which may be used in the invention. As a binder for dispersing the ferrite, a common material such as acrylic resin or silicone resin can be used.

Further, on the surface of the metal wire, a heat dissipation coating having heat dissipation properties may be formed for radiating heat generated in the radiating fin 2 where necessary.
The aforementioned coating can be made of material containing various pigments having a thermal radiation effect. As an example of pigment, there can be enumerated carbon black, alumina, zirconia, titania, silica, zircon, magnesia, yttria (Y₂O₃), cordierite (2MgO·2Al₂O₃· 5SiO₂), and aluminum titanate (Al₂O₃·TiO₂). There may be used either or a combination of these ingredients. The amount of the pigment contained in the coating is arbitrarily determined according to the required heat dissipation capacity, and in general, should be suitably at a rate of 10 to 90 percent by mass of the coating in its dry condition. A material hard to deteriorate with heat is suitable for the binder, e.g. acrylate resin, silicone resin, urethane resin, polyester resin and fluorocarbon polymer.
It is appropriate to determine the thickness of the heat dissipation coating to 1 to 50 µm. The coating of less than 1 µm in thickness is not recommendable because it has a thermal radiation effect.

In a soldering process, a solder strip 3 is put into each of the insertion grooves 11 formed in the radiating substrate 1 as shown in FIG 1(A), and then, the radiating fins 2 are respectively fitted into each insertion groove 11 stuffed with the solder strip 3 as shown in FIG 1 (B). Subsequently, the solder strip 3 is molten with a suitable heater in the state of holding the radiating fins 2 on the radiating substrate 1 as shown in FIG 1(C).

When soldering, the solder 3 in the state molten by heat is prevented from flowing out by the insertion grooves 11 in the radiating substrate 1, as the result of which the molten solder infiltrates toward the center parts 211 and 221 of the radiating substrate from the side edge portions 213 and 223 of the radiating fin having the complex uneven surface by capillary action. Therefore, soldering deposit resulting from the molten solder 3 is widely spread in a strip form over the punctate contact portions between the flat surface of the radiating substrate 1 and the curved parts of the radiating fins 2, consequently to increase the strength of the union between the radiating substrate 1 and radiating fins 2 and improve the heat conductivity between the radiating substrate 1 and the radiating fins 2. The amount of the solder 3 should be determined to bring the coils 21 and 22 into steady contact with the molten solder 3 as shown in FIG 5.

The first embodiment of the heat sink made by soldering makes it possible to secure densely the radiating substrate 1 and radiating fins 2 and significantly improve the heat conductivity between the radiating substrate 1 and the radiating fins 2 due to the small thickness S of the radiating fin 2. By designing the depth d of each insertion groove 11 so as to bring parts of the flat surfaces 212 and 222 of the coils 21 and 22 of the radiating fins 2 into contact with the side walls of the insertion grooves 11 in the radiating substrate 1, the contact area between the radiating substrate 1 and the radiating fins 2 can be enlarged consequently to further improve the heat conductivity between the radiating substrate 1 and the radiating fins 2.

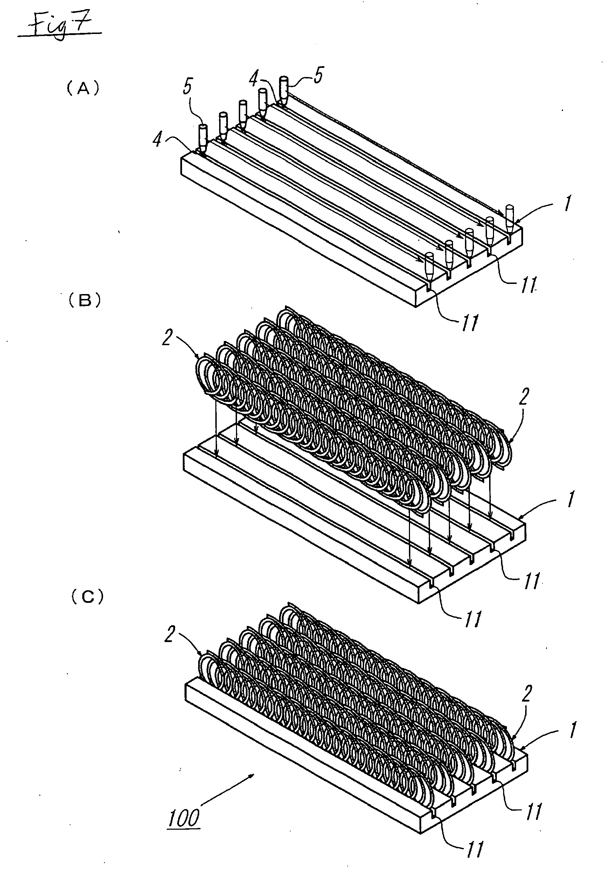

FIG 6 shows the modified example of the radiating substrate 1 in the aforementioned first embodiment. The radiating substrate 1 in this embodiment has the insertion grooves 11 formed by arranging spacer plates 12 such as of metallic material having high thermal conductivity at intervals on the radiating substrate. This embodiment having the insertion grooves is effective for the radiating substrate 1 formed of a material hard to process.

FIG 7 shows the second embodiment of the best mode for practicing the method for manufacturing the heat sink 100 according to the invention.

In this second embodiment, the radiating substrate 1 and radiating fins 2 are secured with thermally-conductive adhesive 4.

The radiating substrate 1 and radiating fins 2 are the same as those in the first embodiment.

The thermally-conductive adhesive 4 is made by mixing metal powder such as of gold, silver, nickel or the like and/or power of alumina, alumina nitride, silicon nitride, carbon or the like with a binder such as of epoxy resin, silicon resin, acrylate resin, urethane resin or the like.

The thermally-conductive adhesive 4 may be sprayed intensively onto the insertion grooves 11 in the radiating substrate 1 by using a nozzle 5 as shown in FIG 7(A).

The other function and effect of the second embodiment are much the same as the first embodiment processed by soldering, exclusive of the difference between the solder 3 and the thermally-conductive adhesive 4.

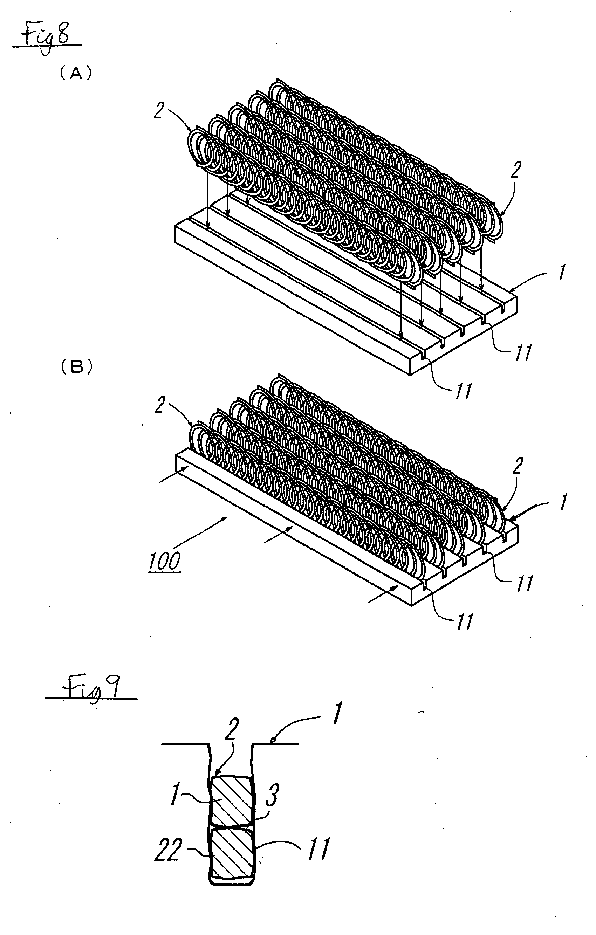

FIG 8 and FIG. 9 show the third and fourth embodiments of the best mode for practicing the method for manufacturing the heat sink 100 according to the invention.

In the third and fourth embodiments, the radiating substrate 1 and radiating fins 2 are secured by deforming the insertion grooves 11 in the radiating substrate 1.

The radiating substrate 1 and radiating fins 2 in the third and fourth embodiments are the same as that in the first embodiment.

In the third embodiment as shown in FIG 8, after inserting the radiating fins 2 into the insertion grooves 11 in the radiating substrate 1, the insertion groove 11 in the radiating substrate 1 is deformed by calking under pressure in the width direction to unite the radiating fins 2 to the radiating substrate 1.

In the third embodiment, the side edge portions 213 and 223 having the complex uneven surfaces of the coils 21 and 22 of the radiating fins 2 fitted into the insertion grooves 11 are more intricately deformed as the insertion grooves 11 in the radiating substrate 1 are deformed Thus, the punctate contact portions between the flat surface of the radiating substrate 1 and the curved portions of the radiating fins 2 are significantly enlarged consequently to increase the strength of the union between the radiating substrate 1 and radiating fins 2 and improve the heat conductivity between the radiating substrate 1 and the radiating fins 2.

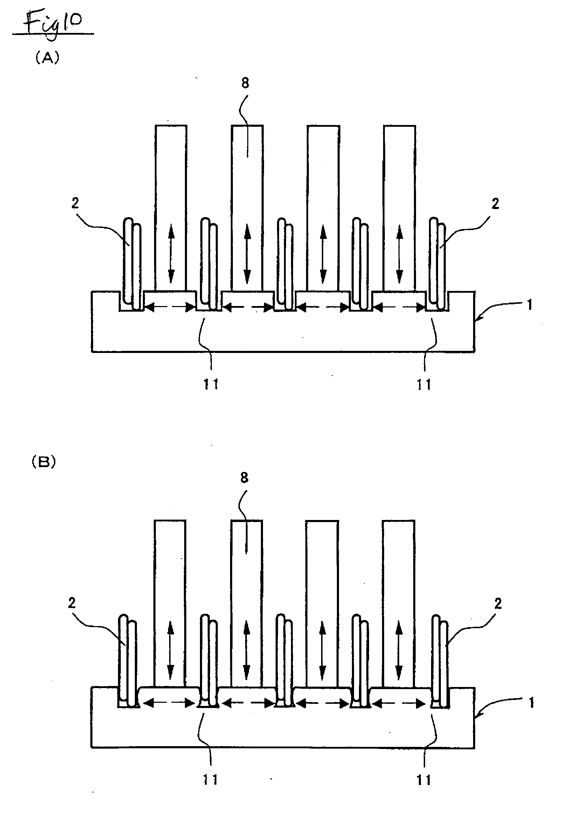

In the fourth embodiment as shown in FIG 10, after inserting the radiating fins 2 into the insertion grooves 11 in the radiating substrate 1, the parts in the vicinity of the insertion grooves 11 in the radiating substrate 1 are deformed under vibrational pressure imparted by a vibration pressure plate 8. Thus, the insertion grooves 11 are deformed under vibrational pressure imparted by the vibration pressure plate 8 to bring the radiating fins 2 into press contact with the radiating substrate 1. High frequency vibration enables prompt uniting of the radiating substrate 1 and radiating fins 2.

In the forth embodiment, the side edge portions 213 and 223 having the complex uneven surfaces of the coils 21 and 22 of the radiating fins 2 fitted into the insertion grooves 11 are more intricately deformed as the insertion grooves 11 in the radiating substrate 1 are deformed. Thus, the punctate contact portions between the flat surface of the radiating substrate 1 and the curved portions of the radiating fins 2 are significantly enlarged consequently to increase the strength of the union between the radiating substrate 1 and radiating fins 2 and improve the heat conductivity between the radiating substrate 1 and the radiating fins 2.

Although the deforming of the insertion grooves 11 in the radiating substrate 1 can be fulfilled by calking under pressure imparted on the radiating substrate 1 in the width direction of the insertion grooves 11 as in the third embodiment, or by the vibrational pressure imparted the portions in the vicinity of the insertion grooves 11 in the radiating substrate 1 as in the fourth embodiment, there may be alternatively employed heat treatment in which while widening the insertion grooves 11 in the radiating substrate 1 due to thermal expansion on heating, the radiating fins 2 are inserted into the insertion grooves, and thereafter, the entire is cooled to deflate the insertion grooves.

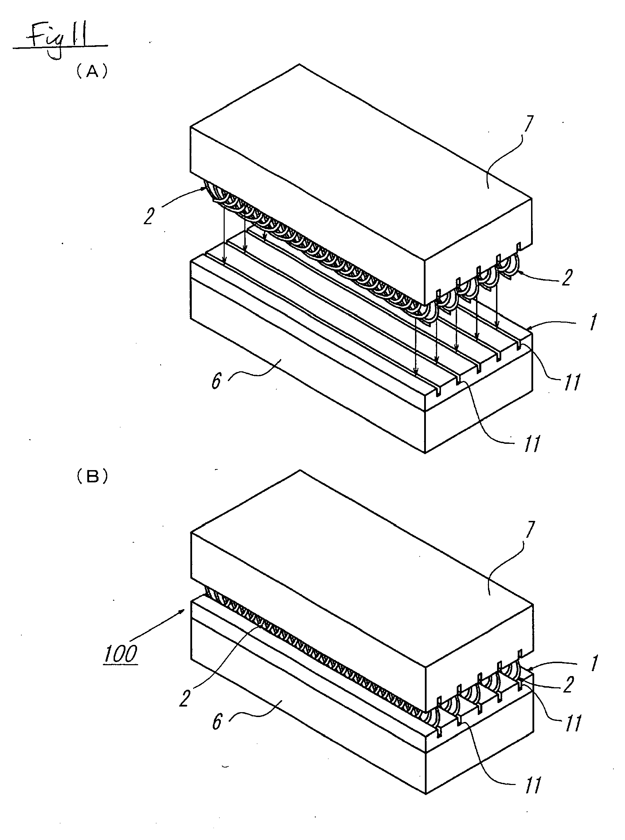

FIG 11 shows the fifth embodiment of the best mode for practicing the method for manufacturing the heat sink 100 according to the invention.

In the fifth embodiment, the radiating substrate 1 and radiating fins are secured by welding.

The radiating substrate 1 and radiating fins are the same as those in the first embodiment.

In the fifth embodiment, the radiating fins 2 are fitted into the insertion grooves in the radiating substrate 1 fixed on a holder base 6 while being held by a support frame 7 having slits corresponding to the insertion grooves 11 of the radiating substrate 1 and united with the radiating substrate by welding. In this case, flash welding or vibrational welding (ultrasonic welding) may be adopted.

In flash welding, in the state that the radiating fins 2 integrally held by the support frame 7 are inserted into the insertion grooves 11 in the radiating substrate 1, contact material for connecting the radiating fins 2 with the radiating substrate 1 is repeatedly scattered by welding current and welded under high pressure while being heated sufficiently. The radiating fins 2 are not warped out of shape by the support frame 7.

In vibration welding (ultrasonic welding), in the state that the radiating fins 2 integrally held by the support frame 7 are inserted into the insertion grooves 11 in the radiating substrate 1, the contact portions are subjected to solid-state welding due to friction caused by pressure and powerful ultrasonic vibration imparted to the radiating fins 2. The vibration can be uniformly transmitted to the entire radiating fins 2 held by the support frame 7.

The molten materials brought about by welding the radiating substrate 1 and radiation fins 2 have the same function and effect as the solder 3 in the first embodiment.

As the other examples than the illustrated embodiments except for the third and fourth embodiments, the radiating fins 2 may be secured on the radiating substrate 1 by using a jig or other possible tools without forming the insertion grooves 11 in the radiating substrate 1.

Although the radiating fin 2 in the aforementioned embodiment is made of the entirely flattened metal wire wound in a coil, the invention should not be understood as being limited thereto. The metal wire applied for the radiating fin may be flattened in part. For instance, only the side edge portions of the radiating fin to be in contact with the radiating substrate may be made flat, so that the side edge portions in contact with the radiating substrate have complex uneven surface of the densely coiled metal wire while assuming coarsely coiled metal wire at the other portions than the side edge portions at the central part of the radiating substrate to substantially expand the heat dissipation space.

In this case, the heat generated in the radiating substrate is transmitted to the entire radiating fins through the side edge portions of the densely coiled metal wire. The heat spread throughout the radiating fins is promptly released from the heat dissipation space defined in the central part of the coarsely coiled metal wire. Furthermore, since the coiled metal wire is partially flattened, the forming cost can be reduced.

## Claims

1. A method for manufacturing a heat sink having radiating fins formed by winding a metal wire into a coil and secured on radiating substrate, wherein said radiating fins are formed by flattening said radiating fins to bring flattened loops of said coiled radiating fins of metal wire into close contact with one another and securing the flattened side edge portions of said radiating fins onto said radiating substrate by soldering.

2. A method for manufacturing a heat sink having radiating fins formed by winding a metal wire into a coil and secured on radiating substrate, wherein slit-like insertion grooves are formed in said radiating substrate and said radiating fins are formed by flattening said radiating fins to bring flattened loops of the coiled radiating fins of metal wire into close contact with one another and inserting the flattened side edge portions of said radiating fins into said insertion grooves in said radiating substrate to be secured onto said radiating substrate by soldering.

3. A method for manufacturing a heat sink having radiating fins formed by winding a metal wire into a coil and secured on radiating substrate, wherein said radiating fins are formed by flattening said radiating fins and said radiating fins having side edge portions adhered to said radiating substrate with a heat conductive adhesive while being in contact with said radiating substrate.

4. A method for manufacturing a heat sink having radiating fins formed by winding a metal wire into a coil and secured on radiating substrate, wherein that slit-like insertion grooves are formed in said radiating substrate and said radiating fins are formed by flattening said radiating fins to bring flattened loops of the coiled radiating fins of metal wire into close contact with one another and inserting the flattened side edge portions of said radiating fins into said insertion grooves in said radiating substrate to be secured onto said radiating substrate by the adhesive.

5. A method for manufacturing a heat sink having radiating fins formed by winding a metal wire into a coil and secured on radiating substrate, wherein that slit-like insertion grooves are formed in said radiating substrate and said radiating fins are formed by flattening said radiating fins so as to bring flattened loops of the coiled radiating fins of metal wire into close contact with one another, inserting the flattened side edge portions of said radiating fins into said insertion grooves in said radiating substrate, and securing said radiating fins onto said radiating substrate by deforming said insertion grooves under pressure.

6. A method for manufacturing a heat sink having radiating fins formed by winding a metal wire into a coil and secured on radiating substrate, wherein that slit-like insertion grooves are formed in said radiating substrate and said radiating fins are formed by flattening said radiating fins to bring flattened loops of the coiled radiating fins of metal wire into close contact with one another, inserting the flattened side edge portions of said radiating fins into said insertion grooves in said radiating substrate, and securing said radiating fins onto said radiating substrate by deforming said insertion grooves under vibrational pressure.

7. A method for manufacturing a heat sink having radiating fins formed by winding a metal wire into a coil and secured on radiating substrate, wherein that said radiating fins are formed by flattening said radiating fins so as to bring flattened loops of the coiled radiating fins of metal wire into close contact with one another and securing the flattened side edge portions of said radiating fins onto said radiating substrate by flash welding.

8. A method for manufacturing a heat sink having radiating fins formed by winding a metal wire into a coil and secured on radiating substrate, wherein that slit-like insertion grooves are formed in said radiating substrate and said radiating fins are formed by flattening said radiating fins to bring flattened loops of the coiled radiating fins of metal wire into close contact with one another and inserting the flattened side edge portions of said radiating fins into said insertion grooves in said radiating substrate to be secured onto said radiating substrate by flash welding.

9. A method for manufacturing a heat sink having radiating fins formed by winding a metal wire into a coil and secured on radiating substrate, wherein that said radiating fins are formed by flattening said radiating fins to bring flattened loops of the coiled radiating fins of metal wire into close contact with one another and securing the flattened side edge portions of said radiating fins onto said radiating substrate by vibrational welding.

10. A method for manufacturing a heat sink having radiating fins formed by winding a metal wire into a coil and secured on radiating substrate, wherein that slit-like insertion grooves are formed in said radiating substrate and said radiating fins are formed by flattening said radiating fins to bring flattened loops of the coiled radiating fins of metal wire into close contact with one another and inserting the flattened side edge portions of said radiating fins into said insertion grooves in said radiating substrate to be secured onto said radiating substrate by vibrational welding.

11. The method for manufacturing a heat sink according to any of claims 1, 3, 7 and 9, wherein only the side edge portions of said radiating fins to touch said radiating substrate are flattened.

12. The method for manufacturing a heat sink according to any of claims 2, 4, 5, 6, 8 and 10, wherein only the side edge portions of said radiating fins to be fitted into said insertion grooves in said radiating substrate are flattened.
